# EUROPÄISCHE PATENTSCHRIFT

(11) **EP 3 815 477 B1**
(45) Veröffentlichungstag und Bekanntmachung des Hinweises auf die Patenterteilung: **30.04.2025**
(21) Anmeldenummer: 19727344.4
(22) Anmeldetag: 27.05.2019
(51) Int. Cl.: H05K 5/06, B23K 26/20, B23K 26/242, B23K 26/28, B23K 26/32, B23K 101/04, B23K 101/36, B23K 103/10

(54) **HERSTELLUNGSVERFAHREN EINES GEHÄUSES FÜR EINE ELEKTRONIK**
METHOD FOR PRODUCING A HOUSING FOR AN ELECTRONIC SYSTEM
PROCÉDÉ DE FABRICATION D'UN BOÎTIER POUR UNE ÉLECTRONIQUE

(30) Priorität: 29.06.2018 DE 102018210773
(43) Veröffentlichungstag der Anmeldung: 05.05.2021
(73) Patentinhaber: Robert Bosch GmbH, 70442 Stuttgart (DE)
(72) Erfinder: SOLF, Christian, 76287 Rheinstetten (DE); STRITT, Peter, 71229 Leonberg (DE)
(86) Internationale Anmeldenummer: PCT/EP2019/063566
(87) Internationale Veröffentlichungsnummer: WO 2020/001881

(56) Entgegenhaltungen:
- EP-A2- 1 087 134
- EP-A2- 1 647 350
- EP-A2- 2 768 295
- WO-A1-2018/072163
- DE-A1- 102014 222 006
- DE-A1- 102016 115 437

## Beschreibung

Die Erfindung geht aus von einem Verfahren zur Herstellung eines Gehäuses für eine Elektronik und einem erfindungsgemäßen Elektronikgehäuse.

### Stand der Technik

Es ist schon ein Verfahren zur Herstellung eines Gehäuses für eine Elektronik, mit einem ersten Gehäuseelement und einem zweiten Gehäuseelement bekannt. Die bekannten Verfahren zur Herstellung eines Gehäuses verbinden die Gehäuseelemente mittels einer Schraubverbindung. Die Abdichtung verfolgt durch eine Dichtung, die zwischen dem ersten und dem zweiten Gehäuseelement angeordnet ist. Für die Herstellung wird eine Vielzahl an Verfahrensschritten benötigt, was wiederum mit erhöhten Herstellungskosten einhergeht.

Es ist auch bekannt, die Gehäuseelemente mittels Einlagen-Laserstrahlschweißen zu verbinden. Dieses Verfahren ist jedoch anfällig für Schweißfehler, was mit einer mangelnden Dichtigkeit des Gehäuses einhergehen kann. Schweißfehler der hier zur Rede stehenden Art können vielfältige Ursachen haben. Insbesondere beim Schweißen von Aluminiumdruckgusslegierungen stellen sich besondere Herausforderungen. So können beispielsweise Lufteinschlüsse im Material, welche während dem Laserschweißen geöffnet werden, Durchbrüche in der Schweißnaht verursachen. Ferner können Wasserstoffeinschlüsse und Legierungselemente während dem Lasterstrahlverfahren freigesetzt werden und in der Schweißnaht Poren bilden.

Die DE 10 2014 222006 A1 offenbart ein Verfahren zur Herstellung eines Gehäuses für eine Elektronik, wobei die Gehäuseelementes des Gehäuses miteinander verschweißt werden. Die EP 2 768 295 A2 offenbart ein Gehäuse, aufweisend ein erstes Gehäuseelementes und ein zweites Gehäuseelemente, wobei die Gehäuseelemente unter Verwendung eines Verbindungsprozesses verbindbar sind.

Aus der EP 1 087 134 A2 ist ein Verfahren zur Herstellung eines Gehäuses bekannt, wobei das Gehäuse durch ein erstes Gehäuseelement und ein zweites Gehäuseelement gebildet wird. Hierbei umfassen die Gehäuseelemente Aluminium oder eine Aluminiumlegierung und mindestens eines der Gehäuseelemente mittels eines Druckgussverfahrens hergestellt. Die Gehäuseelemente sind zumindest teilweise mittels Mehrlagen-Laserstrahlschweißens, insbesondere Zweilagen-Laserstrahlschweißens, verbunden.

Weiterer Stand der Technik ist mit der EP 1 647 350 A2, der WO 2018/072163 A1 und der DE 10 2016 115437 A1 bekannt geworden.

### Offenbarung der Erfindung

### Vorteile der Erfindung

Die Erfindung geht aus von einem Verfahren zur Herstellung eines Gehäuses, insbesondere eines Gehäuses für eine Elektronik, insbesondere zur Steuerung eines Elektromotors, wobei das Gehäuse durch ein erstes Gehäuseelement und ein zweites Gehäuseelement gebildet wird, wobei die Gehäuseelemente Aluminium oder eine Aluminiumlegierung umfassen, und mindestens eines der Gehäuseelemente mittels eines Druckgussverfahrens hergestellt wird. Es wird vorgeschlagen, dass die Gehäuseelemente zumindest teilweise mittels Mehrlagen-Laserstrahlschweißen, insbesondere Zweilagen-Laserstrahlschweißen miteinander fluiddicht verbunden sind.

Das erfindungsgemäße Verfahren zur Herstellung eines Gehäuses und das mittels eines solchen Verfahren hergestellte Elektronikgehäuse mit den Merkmalen der unabhängigen Ansprüche hat den Vorteil, dass eine kostengünstige und gleichzeitig fluiddichte Verbindung zwischen den Gehäuselementen bereitgestellt werden kann. Durch eine solche Mehrlagen-Laserschweißnaht kann in vorteilhafter Weise die Dichtigkeit erhöht werden. Indes wird die im Gehäuse angeordnete Elektronik durch die schmale Wärmeeinflusszone des Laserstrahlschweißens minimal beeinflusst. Das Setzten der weiteren Schweißnahtlagen kann besonders vorteilhaft und flexibel in den Bereichen der ersten Schweißnahtlage erfolgen in welchen eine Undichtigkeit festgestellt oder vermutet wird. Auf diese Weise können die Montagezeiten und damit einhergehend die Bauteilkosten zusätzlich reduziert werden.

Hat die Schmelze, bzw. das flüssige Aluminium oder die flüssige Aluminiumlegierungen an der Oberfläche Kontakt mit Feuchtigkeit, bzw. Wasser aus der Luft, so kann dies zu Fehlbildungen, Poren oder Gaseinschlüssen führen. Das Wasser aus der Luft reagiert mit dem flüssigen Aluminium zu Aluminiumoxid und Wasserstoff. Der Wasserstoff geht in der Schmelze in Lösung. Wasserstoff ist in flüssigem Aluminium sehr gut löslich. Bei der Erstarrung der Aluminiumschmelze nimmt die Löslichkeit des Wasserstoffs sprunghaft ab, und es können mit Wasserstoff gefüllte Poren im Gefüge entstehen. Diese Wasserstoffeinschlüsse können während des Laserschweißens der ersten Schweißnahtlage freigesetzt werden und somit Öffnungen und Poren in der Schweißnaht selbst verursachen, welche in vorteilhafter Weise mit der darauffolgenden Schweißnahtlage verschlossen werden können, sodass ein fluiddichter Elektronikraum im Gehäuse bereitgestellt werden kann.

Auch freigesetzte Lufteinschlüsse, die Ausgasung von Legierungselementen aus dem Gefüge, Wasserstoffeinlagerungen in der Oxidschicht an der Oberfläche der Gehäuseelemente sowie aus dem Gießprozess der Druckgusslegierung an der Oberfläche verbleibende Öle und Fette können bei der Verbindung von Gehäuseelementen aus Aluminium zu einer mangelnden Dichtigkeit in einer ersten Schweißnahtlage führen. Wie bereits erläutert, können diese Schweißfehler mit einer oder mehreren auf der ersten Laserschweißnahtlage angeordneten, zusätzlichen Laserschweißnahtlagen verschlossen werden, sodass eine fluiddichte Verbindung zwischen den Gehäuseelementen bereitgestellt werden kann. In Abhängigkeit der gewünschten Laserschweißnahtgüte kann es überdies vorgesehen sein, dass nach dem Einbringen einer zweiten Laserschweißnahtlage eine oder mehrere weitere Schweißnahtlagen auf der zweiten Schweißnahtlage aufgebracht werden.

Das zumindest teilweise Mehrlagen-Laserstrahlschweißen der Gehäuseelemente ermöglicht somit in vorteilhafter Weise die Bereitstellung einer präzisen, schmalen Laserschweißnaht, welche insbesondere im Wesentlichen porenfrei ausgebildet ist. Gleichzeitig kann durch den vergleichsweise geringen Wärmeeintrag des Mehrlagen-Laserstrahlschweißens gegenüber anderen Schweißverfahren eine ungewünschte thermische Beeinflussung der Elektronik in vorteilhafter Weise minimiert beziehungsweise verhindert werden. Das Verbinden der Gehäuseelemente mittels Mehrlagen-Laserstrahlschweißen stellt ferner ein besonders einfaches und kostengünstiges Verfahren zur fluiddichten Verbindung unter minimaler thermischer Beeinflussung einer im Gehäuse angeordneten Elektronik dar.

Im Rahmen der vorliegenden Erfindung kann unter einem Druckgussverfahren ein Gussverfahren verstanden werden, bei welchem die Schmelze unter hohem Druck in eine Dauerform eingepresst wird, wobei während der Erstarrung vorzugsweise der Druck aufrecht gehalten wird. Das im Druckgussverfahren hergestellte Gehäuseelement bestehen aus Aluminium, insbesondere einer Aluminiumlegierung, vorzugsweise AlSi12(Fe), Legierung 230.

Durch die in den Unteransprüchen aufgeführten Maßnahmen ergeben sich vorteilhafte Weiterbildungen und Verbesserungen der im Hauptanspruch angegebenen Merkmale.

Gemäß einer vorteilhaften Weiterbildung der Erfindung ist es ferner vorgesehen, dass zumindest eine Schweißnahtlage des Mehrlagen-Laserstrahlschweißens mittels Strahlenoszillation durchgeführt wird. Durch die Strahloszillation und das damit einhergehende erneute Überfahren von bereits geschmolzenem Werkstoff können in vorteilhafter Weise Poren in der Schweißnaht effektiv reduziert werden, was eine hohe Oberflächengüte der Mehrlagen-Laserschweißnaht zur Folge hat. Durch die Überlagerung der Laserschweißvorschubbewegung mit einer zirkularen Oszillationstrajektorie kann der lokale Energieeintrag derart verbessert werden, dass eine besonders dichte und möglichst fehlerfreie Verbindung zwischen den Gehäuseelementen bereitgestellt werden kann. Neben einer solchen zirkularen Oszillationstrajektorie ist es auch denkbar, dass die Strahlenoszillation einer im Wesentlichen sinusförmigen Kurve folgt. Auch andere Trajektorien des Laserstrahls, wie beispielsweise elliptische oder traversalachtförmige oder longitudinal-achtförmige Strahlenoszillationsformen sind denkbar. Die Strahlenoszillation ermöglicht eine gezielte Einstellung des lokalen Wärmeeintrags und damit einhergehend der Schweißnahtparameter wie der Schweißnahtbreite und Schweißnahttiefe.

Im Rahmen der vorliegenden Erfindung wird unter einer Strahloszillation des Laserstrahls ein Überlagern der Vorschubbewegung mit einer in der Regel harmonischen Schwingung mit einer festen Amplitude in einer oder mehreren Raumrichtungen verstanden werden.

Gemäß einer besonders vorteilhaften Ausführungsform der Erfindung ist die Mehrlagenschweißnaht, welche aus wenigstens einer ersten Schweißnahtlage und wenigstens einer zweiten Schweißnahtlage ausgebildet ist, im Bereich der der freien Oberfläche der Mehrlagenschweißnaht zugewandten Schweißnahtlage, insbesondere im Bereich der zweiten Schweißnahtlage im Wesentlichen porenfrei ausgebildet. Ferner ist die Anzahl der Poren und Einschlüsse gegenüber einer einfachen Laserschweißnahtlage deutlich reduziert, wobei unter dem Begriff deutlich vorzugsweise eine Reduzierung um mindestens die Hälfte, besonders bevorzugter Weise um mehr als 80% der Poren beziehungsweise Einschlüsse verstanden werden kann.

Eine bevorzugte Ausführungsform der Erfindung sieht ferner vor, dass das Verhältnis zwischen der Vorschubgeschwindigkeit des Laserstrahls in [mm/s] und der überlagerten Strahlenoszillation des Laserstrahls in [Hz] zwischen 0,2 (mm/s)/Hz und 0,4 (mm/s)/Hz, insbesondere im Wesentlichen zwischen 0,25 (mm/s)/Hz und 0,35 (mm/s)/Hz ausgebildet ist. Ein solches Verhältnis ermöglicht einen optimalen, lokalen Wärmeeintrag, welcher Aufgrund der variierenden Bahngeschwindigkeit bei einer zirkularen Oszillationstrajektorie entscheidend vom Verhältnis zwischen der Vorschubgeschwindigkeit und der Strahlenoszillationsfrequenz abhängt. Auf diese Weise kann eine qualitativ hochwertige, fluiddichte Laserschweißnaht mit optimierter Gefügestruktur bereitgestellt werden. Insbesondere bei einem Verhältnis von Vorschubgeschwindigkeit zu Strahlenoszillation im Bereich zwischen 0,25 (mm/s)/Hz und 0,35 (mm/s)/Hz kann sichergestellt werden, dass eine ausreichende Überlagerung zweier aufeinanderfolgender Oszillationen bereitgestellt wird um eine derart optimierte Gefügestruktur bereitzustellen.

Gemäß einer vorteilhaften Ausführungsform der Erfindung kann es überdies vorgesehen sein, dass die Breite der Schweißnaht der ersten Schweißnahtlage kleiner als die Breite der Schweißnaht der zweiten Schweißnahtlage ausgebildet ist und/oder dass die Tiefe der Schweißnaht der ersten Schweißnahtlage größer als die Tiefe der Schweißnaht der zweiten Schweißnahtlage ausgebildet ist. Auf diese Weise kann sichergestellt werden, dass die zweite Schweißnahtlage die freie Oberfläche der ersten Schweißnahtlage vollständig überdeckt und somit die Dichtigkeit gegenüber in das Gehäuse eindringenden Fluiden beziehungsweise Flüssigkeiten sichergestellt werden kann. Eine solche Einstellung der Breiten und Tiefen der Schweißnahtlagen lässt sich insbesondere bereitstellen, dass das Lasterstrahlverfahren mittels Strahlenoszillation, insbesondere zirkularer Strahlenoszillation durchgeführt wird.

Eine vorteilhafte Weiterbildung der Erfindung sieht vor, dass lediglich in Bereichen in welchen der Laserschweißnahtverlauf eckig ausgebildet ist, die Schweißnaht als Mehrlagen-Laserschweißnaht ausgebildet ist. Auf diese Weise kann das erneute Überfahren der ersten Schweißnaht auf Bereiche reduziert werden, in welchen Schweißfehler mit einer erhöhten Wahrscheinlichkeit auftreten. Auf diese Wiese können die Fertigungskosten vorteilhaft gesenkt werden. Vorzugsweise wird in diesem Zusammenhang unter einem eckigen Schweißnahtverlauf ein solcher Verlauf verstanden, welcher eine Richtungsänderung der Vorschubrichtung des Laserkopfes um mehr als 45° erforderlich macht. Besonders bevorzugter Weise ist die Schweißnaht in Bereichen in welchen der Schweißnahtverlauf im Wesentlichen einer S-förmigen Kurve folgt als Mehrlagen-Laserschweißnaht ausgebildet.

Eine fluiddichte Verbindung der Gehäuseelemente bei gleichzeitig minimaler Beeinflussung der im Gehäuse angeordneten Elektronik kann insbesondere dadurch bereitgestellt werden, dass der Radius der im Wesentlichen zirkularen Laserstrahltrajektorie der zweiten Schweißnahtlage größer, insbesondere zwischen 20% und 40% größer, vorzugsweise zwischen 30% und 35% größer als der Radius der im Wesentlichen zirkularen Laserstrahltrajektorie der ersten Schweißnahtlage ausgebildet ist. Eine derartige Schweißnahtform ermöglicht eine sichere Überdeckung der ersten Schweißnahtlage mit der zweiten Schweißnahtlage und damit einhergehend eine Minimierung der Fehleranfälligkeit der Mehrfachschweißnaht bei gleichzeitiger Bereitstellung einer schmalen Schweißnaht.

Gemäß einer vorteilhaften Ausführungsform der Erfindung ist das zweite Gehäuseelement als Deckel für das erste Gehäuseelement ausgebildet, wobei das erste Gehäuseelement eine Aussparung aufweist, welche vom zweiten Gehäuseelement abgedeckt wird. Auf diese Weise kann durch Verbindung der beiden Gehäuseelemente mittels dem erfindungsgemäßen Laserstrahlverfahren beziehungsweise Merhrlagen-Laserstrahlverfahren ein abgedichteter Gehäuseinnenraum für die Elektronik ohne zusätzliche Gehäuseteile oder zusätzlich eingebrachte Materialien bereitgestellt werden. Vorzugsweise liegt zu diesem Zweck das als Deckel ausgebildete zweite Gehäuseelement vor dem Mehrlagen-Laserstrahlschweißen im Wesentlichen spaltfrei kontaktierend am ersten Gehäuseelement an.

Eine vorteilhafte Ausführungsform der Erfindung sieht vor, dass das erste Gehäuseelement und das zweite Gehäuseelement im in einem Winkelstoß, insbesondere einem Bördelstoß zueinander angeordnet sind. Ferner ist es vorgesehen, dass die Mehrlagen-Laserschweißnaht als Stirnflachnaht ausgebildet ist. Ein solcher Bördelstoß kann insbesondere dadurch bereitgestellt werden, dass das als Deckel ausgebildete zweite Gehäuseelement in Laserstrahlerstreckungsrichtung über die Kontur des erstenGehäuseelementes hinaussteht, wobei der Deckel im Wesentlichen wannenförmig ausgebildet ist. Der überstehende Deckelrand des abgewinkelten, blechförmigen Deckels (Bördel) kann dabei in vorteilhafter Weise als Schweißgut genutzt werden und während des Laserstrahlschweißens mit aufgeschmolzen werden.

Eine weitere vorteilhafte Ausführungsform der Erfindung sieht vor, dass die zweite Schweißnahtlage als Schweißnaht mit ungleichen Schenkeln ausgebildet ist, wobei der lange Schenkel der Schweißnaht dem mittels Durchgussverfahren hergestellten Gehäuseelement zugewandt ausgebildet ist. Insbesondere bei einem aus einer Knetlegierung ausgebildeten Deckel, treten Schweißnahtfehler wie Poren und Löcher vorzugsweise im Bereich des mittels Druckgussverfahrens hergestellten Gehäuselementes auf. Eine vergrößerte Überdeckung der ersten Schweißnahtlage mit der entsprechenden zweiten Schweißnahtlage im Bereich des mittels Druckgussverfahrens hergestellten Gehäuseelementes ermöglicht in vorteilhafter Weise eine vergrößerte Anbindung in Bereichen einer höheren Auftrittwahrscheinlichkeit von Schweißfehlern.

Besonders vorteilhaft ist, dass zumindest ein Gehäuseelement mittels eines Umformverfahrens hergestellt wird. Vorteilhaft wird ein Gehäuseelement durch Tiefziehen geformt. Das Ausgangsmaterial zur Herstellung des Gehäuseelements mittels Tiefziehen ist eine, insbesondere fehlerfreie und porenfreie, Knetlegierung. Das Tiefziehen gemäß dem Verfahren erlaubt die Herstellung eines fehlerfreien, insbesondere porenfreien, dünnwandigen, leichten, Gehäuseelements. Als weiteren Vorteil ist anzusehen, dass das Tiefziehen ein einfaches und kostengünstiges Verfahren zur Herstellung eines Gehäuseelementes darstellt. Das aus einer Knetlegierung tiefgezogene Gehäuseelement umfasst vorzugsweise Aluminium, insbesondere eine Aluminiumlegierung, vorzugsweise AlMg3 oder AlSi1,2Mg0,4. Vorteilhaft ist, dass der Kupfergehalt der Legierungen gering, insbesondere kleiner als 0,3 % ist. Auch ist der Einsatz von anderen Aluminiumlegierungen möglich.

Vorzugsweise wird das das mittels Druckgussverfahren hergestellte Gehäuseelement aus einer vor dem Einbringen in eine Druckgussform, insbesondere ausreichend, entgasten Schmelze hergestellt, wobei das Druckgussverfahren in einer Schutzatmosphäre, insbesondere einer Atmosphäre aus Stickstoff, durchgeführt wird. Durch die Entgasung der Schmelze wird verhindert, dass die Schmelze beim Gussprozess, beispielsweise mit weiteren Gasen oder mit aus der Schmelze austretenden Gasen reagiert. Durch die Kombination aus entgaster Schmelze und Durchführung des Druckgussverfahrens in einer Stickstoffatmosphäre können Fehlbildungen, Gaseinschlüsse oder Poren bereits vor dem Mehrlagen-Laserstrahlschweißen reduziert werden

Gemäß einer vorteilhaften Ausführungsform der Erfindung wird die Elektronik vor Mehrlagen-Laserstrahlschweißen in einem der Gehäuseelemente angeordnet. Vorzugsweise ist die Elektronik mittig innerhalb der Ausnehmung des ersten Gehäuseelementes angeordnet, sodass ein maximaler Abstand der Elektronik zur Wärmeeinflusszone der Laserschweißnaht bereitgestellt werden kann.

Vorzugsweise findet zum Mehrlagen-Laserstrahlschweißen ein Festkörperlaser, insbesondere ein Nd:YAG-Laser vorzugsweise mit einer Leistung zwischen 1800W und 2000W Anwendung.

Ausführungsbeispiele sind in den Figuren dargestellt und in der nachfolgenden Beschreibung näher erläutert. Es zeigen:
- Figur 1: eine Explosionsdarstellung eines Gehäuses vor dem Fügen,
- Figur 2a: eine Schnittdarstellung einer Ausführungsform des Gehäuses aus Figur 1 vor dem Mehrlagenlaserstrahschweißen,
- Figur 2b: eine Schnittdarstellung einer Ausführungsform des Gehäuses aus Figur 1 nach dem Mehrlagenlaserstrahschweißen,

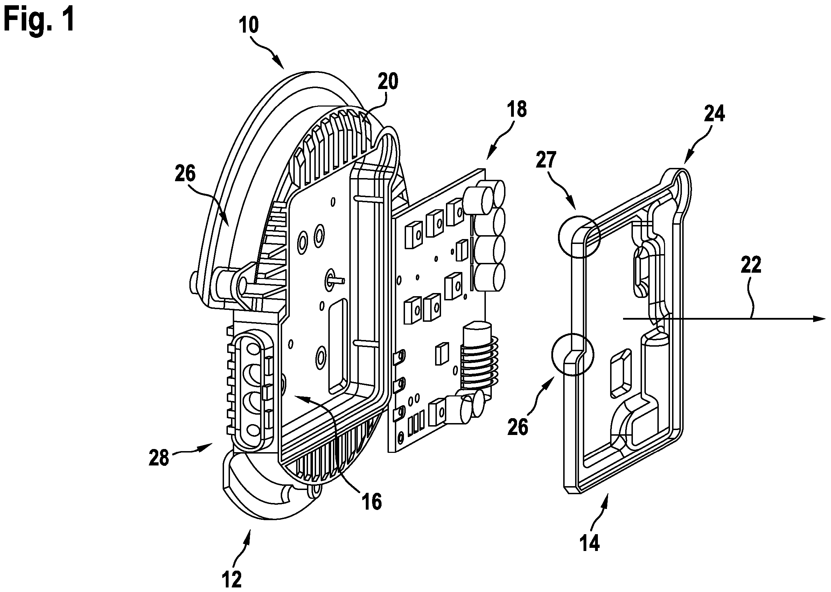

In Figur 1 ist die Explosionsdarstellung eines erfindungsgemäßen Gehäuses 10 gezeigt. Das Gehäuse 10 umfasst ein erstes Gehäuseelement 12 und ein zweites Gehäuseelement 14. Das in Figur 1 dargestellte Gehäuse 10 ist dafür geeignet eine Elektronik 18 zur Steuerung eines Elektromotors aufzunehmen. Es sei an dieser Stelle jedoch ausdrücklich erwähnt, dass auch Anwendungen für ein solches Gehäuse 10 denkbar sind, insofern für diese Anwendungen ein fluiddicht abgedichteter Gehäuseinnenraum erforderlich ist. Wie in Figur 1 deutlich zu erkennen ist, weist das erste Gehäuseelement 12 eine Ausnehmung 16 auf, innerhalb welcher im montierten Zustand die Elektronik 18 angeordnet wird. Entsprechend der Kontur der Elektronik 18 weist die Ausnehmung 16 eine im Wesentlichen rechteckige Form auf. Erfindungsgemäß ist es vorgesehen, dass die Gehäuseelemente 12, 14 ein Aluminium oder eine Aluminiumlegierung umfassen, und mindestens eines der Gehäuseelemente 12, 14 mittels eines Druckgussverfahrens hergestellt ist.

Wie in Figur 1 zu erkennen ist, ist gemäß der hier dargestellten Ausführungsform der Erfindung das erste Gehäuseelement 12 mittels Druckgussverfahren hergestellt und weist an seiner Oberfläche eine Vielzahl an Kühlrippen 20 auf. Mittels der Kühlrippen 20 kann die im Betrieb der Elektronik 18 entstehende Wärme abgeführt werden. Die Wärme wird von der Elektronik 18 an das Gehäuse 10 weitergeleitet. Von dem Gehäuse 10 wird die Wärme mittels Konvektion über die Oberfläche des Gehäuses 10 und die Oberfläche der Kühlrippen 20 abgeführt. Das Gehäuse 10 ist zu diesem Zweck vorteilhaft in einem bewegten Luftstrom angeordnet. Vorzugsweise ist das Gehäuse 10 in einem Luftstrom eines Lüfters, welcher durch einen Elektromotor angetrieben wird, angeordnet, wobei, wie bereits eingangs erläutert, der Elektromotor durch die Elektronik 18 gesteuert wird.

Wie in Figur 1 deutlich zu erkennen ist, ist das zweite Gehäuseelement 14 als Deckel ausgebildet, welcher bei der Montage nach dem Einlegen der Elektronik 18 in die Aussparung 16 des ersten Gehäuseelementes 12 auf der Aussparung 16 angeordnet wird und diese vollständig abdeckt. Zwischen dem ersten Gehäuseelement 12 und dem zweiten Gehäuseelement 14 verbleibt dabei im montierten Zustand der Elektronikraum. Ein solcher Deckel kann gemäß einer bevorzugten Ausführungsform der Erfindung durch das Tiefziehen einer Knetlegierung hergestellt werden. Der in Figur 1 dargestellte Deckel 14 weist eine im Wesentlichen rechteckige, flache Kontur auf, wobei der Deckelrand 24 umlaufend um im Wesentlichen 90° umgebogen ist, sodass der Deckel 14 eine im Wesentlichen wannenförmige Form aufweist.

Wie in Figur 1 zu erkennen ist, weist das erste Gehäuseelement 12 einen umlaufenden Mantel 26 auf. An bzw. in einer Ausnehmung 28 des Mantels 26 ist beispielsweise ein Anschlussstecker, zur Ansteuerung und/ oder Energieversorgung der Elektronik 18 oder zur Ansteuerung und/oder Energieversorgung des Motors angeordnet. Die Elektronik 18 wird vor dem Auflegen des zweiten Gehäuseelementes 14 auf das erste Gehäuseelement 12 im Elektronikraum angeordnet und insbesondere dort fixiert. Gemäß einer weiteren Ausführungsform der Erfindung erfolgt die Fixierung der Elektronik 18 im Gehäuse 10 durch Fixierungselemente, insbesondere Berührpunkt, vorzugsweise Anschläge an den Gehäuseelementen 12, 14. Anschließend werden die beiden Gehäuselemente 12, 14 vollständig umlaufend entlang der Erstreckung des Gehäuserandes 24 in einer ersten Schweißlage laserverschweißt. Wie in Figur 1 deutlich zu erkennen ist, weist das zweite Gehäuseelement 14 und damit einhergehend der dem Gehäuserand 24 folgende Laserschweißnahtverlauf einen Abschnitt 26 auf in welchem der Laser zum Folgen der Krümmung des Deckelrandes 24 zweimal die Vorschubrichtung um etwa 90° ändern muss. In diesem Abschnitt 26 treten vermehrt die eingangs erläuterten Schweißfehler in der ersten Schweißnahtlage auf, welche zu einer mangelnden Abdichtung des Elektronikraumes führen können. Erfindungsgemäß ist es nunmehr vorgesehen, dass durch erneutes Überfahren der ersten Schweißnahtlage wenigstens eine weitere Schweißnahtlage auf der ersten Schweißnahtlage aufgebracht wird. Vorzugsweise erfolgt das Aufbringen der weiteren Schweißnahtlage beziehungsweise Schweißnahtlagen im Abschnitt 26 oder in anderen Abschnitten 27 in welchen die Laservorschubrichtung zum Setzen der entsprechenden Schweißnaht um etwa 90° geändert werden muss.

Die Mehrlagen-Laserschweißnaht stellt eine metallische Verbindung zwischen den beiden Gehäuseelementen 12, 14 her durch welche eine gute Wärmeleitung zwischen den beiden Gehäuseelementen 12, 14 und somit eine effektive Entwärmung des Gehäuses 10, bzw. der Elektronik 18 erreicht werden kann. Im Gegensatz hierzu verhindert oder minimiert eine Nassdichtung wie sie aus dem Stand der Technik bekannt ist die Ausbildung eines Wärmestroms zwischen den Gehäuseelementen 12, 14, sodass nur bedingt ein Wärmeaustausch erfolgen kann. Durch den direkten und umlaufenden metallischen Kontakt der beiden Fügepartner 12, 14 wird zudem eine für die Elektronik 18 positive elektrische Verbindung erzielt. So kann beispielsweise die elektromagnetische Verträglichkeit verbessert werden. Dies ist insbesondere wichtig, wenn die Elektronik 18 vor elektromagnetischen Feldern oder Strahlung des Motors oder die Umgebung vor elektromagnetischer Strahlung oder Feldern der Elektronik 18 geschützt werden soll.

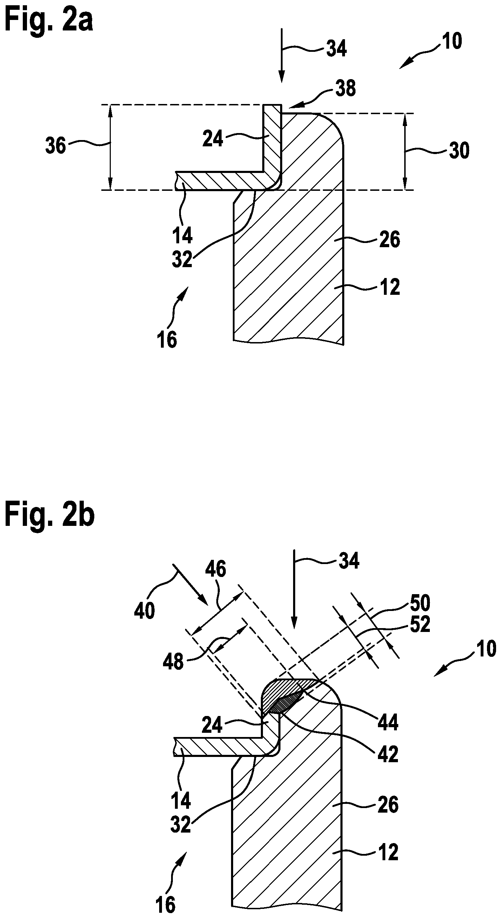

Figur 2a zeigt einen Ausschnitt eines Gehäuses 10 gemäß einer ersten Ausführungsform in einer Schnittdarstellung vor dem Mehrlagen-Laserstrahlschweißen. Gemäß der in Figur 2a dargestellten Ausführungsform der Erfindung sind die beiden Gehäuseelemente 12, 14 in einem Bördelstoß zueinander angeordnet. Zu diesem Zweck weist das zweite Gehäuseelement 14 einen Gehäuserand 24 auf, welcher im Wesentlichen um 90° aus der Erstreckungsebene des zweiten Gehäuseelementes 14 umgebogen ausgebildet ist. Es sei an dieser Stelle jedoch ausdrücklich erwähnt, dass auch andere Ausführungsformen denkbar sind, so ist es beispielsweise auch denkbar, dass die beiden Gehäuseelemente 12, 14 in einem Eckstoß zueinander angeordnet sind.

Das erste Gehäuseelement 12 weist eine innenseitig angeordnete Aussparung 16 auf, welche insbesondere als Stufe im Rand des Mantels 26 des ersten Gehäuseelementes 12 ausgebildet ist. Die Stufe bildet dabei sowohl einen axialen als auch einen radialen Anschlag für das eingelegte Deckelelement 14. Die radiale Höhe 30 der Stufe 32 ist gemäß einer vorteilhaften Weiterbildung der Erfindung im Wesentlichen umlaufend konstant. Eine vorteilhafte Weiterbildung der Erfindung sieht ferner vor, dass der umlaufende Gehäuserand 24 des zweiten Gehäuseelementes 14 eine radiale Höhe 36 aufweist, welche vorzugsweise größer ist als die radiale Höhe 30 der Stufe 32, sodass der Gehäuserand 24 im eingelegten Zustand in Laserstrahlerstreckungsrichtung 34 beziehungsweise in Radialrichtung über die Kontur des ersten Gehäuseelementes 12 hinaussteht. Der Überhang 38 kann in vorteilhafterweise während dem Laserstrahlschweißen aufgeschmolzen werden und als zusätzliches Schweißmittel fungieren.

Wie bereits eingangs erwähnt, sind die Gehäuseelemente 12, 14 aus Aluminium oder einer Aluminiumlegierung hergestellt, wobei wenigstens eines der beiden Gehäuseelemente 12, 14 im Druckgussverfahren hergestellt ist. Beim Druckgussverfahren handelt es sich um ein Urformverfahren, d.h. es wird aus einem flüssigen Ausgangsmaterial, insbesondere eine Schmelze, ein fester Körper hergestellt. Dazu werden, insbesondere hochschmelzende, Legierungen aus Aluminium verwendet, die unter hohem Druck in eine maßgenaue, wiederverwertbare Form, insbesondere eine Stahlform eingespritzt werden, um eine vollständige Befüllung der Gussform zu erzielen. Das erhärtete Gußteil nimmt die Details und Form des Formhohlraums der Gussform mit hoher Präzision an. Der Vorteil des Druckgießens liegt in der hohen Gestaltungsfreiheit. Ein Gehäuseelement 12, 14 für ein Gehäuse 10 einer Elektronik 18 stellt hohe Anforderungen an die Wärmeleitung und Dichtheit. Insbesondere erlaubt das Druckgussverfahren die Ausbildung von Kühlrippen und eine optimale Anpassung der Geometrie des Gehäuseinneren an die dort befindliche Elektronik 18.

Bedingt durch das Druckgussverfahren zur Herstellung der Gehäuseelemente 12, 14 lassen sich Fehlstellen und Gaseinschlüsse, welche zu Poren führen, in der Regel nicht vermeiden. Die Fehlstellungen führen beim Schweißen in der ersten Schweißnahtlage zu undichten Stellen, die eine vollständige Abdichtung des Gehäuses 10 verhindern. Wie bereits erwähnt treten solche Schweißfehler gehäuft in Bereichen 26, 27 auf in welchen der Laserschweißnahtverlauf eckig ausgebildet ist. Eine vorteilhafte Ausführungsform der Erfindung sieht nunmehr vor, dass in diesen Bereichen 26, 27 eine erfindungsgemäße Mehrlagenschweißnaht 40 angeordnet ist. Eine solche Mehrlagenschweißnaht 40 ist in Figur 2b gezeigt.

Wie in den Figuren 2a und 2b zu erkennen ist, wird beim erfindungsgemäßen Mehrlagen-Laserstrahlschweißen der Laserstrahl vorzugsweise mittig zwischen den beiden Gehäuseelementen 12, 14 geführt, wobei sich die Laserstrahlerstreckungsrichtung 34 im Wesentlichen in Radialrichtung des Gehäuses 10 erstreckt. Erfindungsgemäß ist es nunmehr vorgesehen, dass in einem ersten Verfahrensschritt eine erste Schweißnahtlage 42 mittels Laserstrahlschweißen aufgebracht wird. Die erste Schweißnahtlage 42 kann gemäß einer vorteilhaften Ausführungsform der Erfindung mittels Strahlenoszillation des Laserstrahls der eingangs beschriebenen Art aufgebracht werden. Im Anschluss daran wird eine zweite Schweißnahtlage 44 auf der ersten Schweißnahtlage 42 aufgebracht. Durch das Setzten der zweiten Schweißnahtlage 44 können in vorteilhafter Weise Schweißfehler, wie Poren und Einschlüsse der ersten Schweißnahtlage 42 verschlossen werden.

Die Breite 48 der Schweißnaht der ersten Schweißnahtlage 42 ist gemäß der in Figur 2b dargestellten Ausführungsform kleiner als die Breite 46 der Schweißnaht der zweiten Schweißnahtlage 44 ausgebildet. Auf diese Weise kann sichergestellt werden, dass in den entsprechenden Bereichen 26, 27 die gesamte erste Schweißnahtlage 42 von der zweiten Schweißnahtlage 44 überdeckt wird und somit die Dichtigkeit der Gehäuse verbessert wird. Gemäß einer vorteilhaften Weiterbildung der Erfindung ist es zusätzlich oder alternativ hierzu vorgesehen, dass die Tiefe 50 der der ersten Schweißnahtlage 42 größer als die Tiefe 52 der zweiten Schweißnahtlage 44 ausgebildet ist.

## Patentansprüche

1. Verfahren zur Herstellung eines Gehäuses (10) für eine Elektronik (18), insbesondere zur Steuerung eines Elektromotors, wobei das Gehäuse (10) durch ein erstes Gehäuseelement ( 12) und ein zweites Gehäuseelement (14) gebildet wird, wobei die Gehäuseelemente (12, 14) Aluminium oder eine Aluminiumlegierung umfassen, und mindestens eines der Gehäuseelemente (12, 14) mittels eines Druckgussverfahrens hergestellt wird, wobei die Gehäuseelemente (12, 14) zumindest teilweise mittels Mehrlagen-Laserstrahlschweißens miteinander fluiddicht verbunden sind, wobei eine Mehrlagenschweißnaht (40) der Mehrlagen-Laserstrahlschweißen aus wenigstens einer ersten Schweißnahtlage (42) und wenigstens einer zweiten Schweißnahtlage (44) ausgebildet ist, wobei die zweite Schweißnahtlage auf der ersten Schweißnahtlage aufgebracht wird **dadurch gekennzeichnet dass** die Breite (48) der ersten Schweißnahtlage (42) kleiner als die Breite zweiten Schweißnahtlage (44) ausgebildet ist.

2. Verfahren zur Herstellung eines Gehäuses (10) gemäß Anspruch 1, wobei zumindest eine Schweißnahtlage (42, 44) der wenigstens einen ersten Schweißnahtlage (42) und wenigstens einen zweiten Schweißnahtlage (44) mittels Strahlenoszillation, insbesondere mittels im Wesentlichen zirkularer Laserstrahltrajektorie durchgeführt wird.

3. Verfahren zur Herstellung eines Gehäuses (10) gemäß einem der vorhergehenden Ansprüche, wobei die Mehrlagenschweißnaht (40) im Bereich einer, einer freien Oberfläche der Mehrlagenschweißnaht (40) zugewandten Schweißnahtlage (42 ,44) im Wesentlichen porenfrei ausgebildet ist.

4. Verfahren zur Herstellung eines Gehäuses (10) gemäß einem der Ansprüche 2 oder 3, wobei ein Verhältnis zwischen einer Vorschubgeschwindigkeit des Laserstrahls und der Strahlenoszillation des Laserstrahls zwischen 0,2 (mm/s)/Hz und 0, 4 (mm/s)/Hz, insbesondere im Wesentlichen zwischen 0,25 (mm/s)/Hz und 0,35 (mm/s)/Hz ausgebildet ist.

5. Verfahren zur Herstellung eines Gehäuses (10) gemäß einem der vorhergehenden Ansprüche, wobei die Tiefe (50) der ersten Schweißnahtlage (42) größer als die Tiefe (52) der zweiten Schweißnahtlage (44) ausgebildet ist.

6. Verfahren zur Herstellung eines Gehäuses (10) gemäß einem der vorhergehenden Ansprüche, wobei die Mehrlageschweißnaht (40) ausgebildet ist in Bereichen (62, 27), in welchen der Laserschweißnahtverlauf eckig ausgebildet ist

7. Verfahren zur Herstellung eines Gehäuses (10) gemäß einer der vorhergehenden Ansprüche, wenn diese von Anspruch 2 abhängen, wobei die wenigstens eine erste Schweißnahtlage (42) und die wenigstens eine zweite Schweißnahtlage (44) mittels im Wesentlichen zirkularer Laserstrahltrajektorie durchgeführt werden, wobei der Radius der im Wesentlichen zirkularen Laserstrahltrajektorie der zweiten Schweißnahtlage (44) größer, insbesondere zwischen 20% und 40% größer, 30% und 35% größer als der Radius, der im Wesentlichen zirkularen Laserstrahltrajektorie der ersten Schweißnahtlage (42) ausgebildet ist.

8. Verfahren zur Herstellung eines Gehäuses (10) nach einem der vorhergehenden Ansprüche, wobei das zweite Gehäuseelement (14) als Deckel für das erste Gehäuseelement ausgebildet (12) ist, wobei das erste Gehäuseelement (12) eine Aussparung (16) aufweist, welche vom zweiten Gehäuseelement (14) abgedeckt wird.

9. Verfahren zur Herstellung eines Gehäuses (10) nach einem der vorhergehenden Ansprüche, wobei das erste Gehäuseelement (12) und das zweite Gehäuseelement (14) im Laserschweißbereich in einem Winkelstoß, insbesondere einem Bördelstoß zueinander angeordnet sind.

10. Verfahren zur Herstellung eines Gehäuses (10) nach einem der vorhergehenden Ansprüche, wenn diese von Anspruch 8 abhängen, wobei das als Deckel ausgebildete zweite Gehäuseelement (14) in Laserstrahlerstreckungsrichtung (34) in einem Überhang (38) über die Kontur des ersten Gehäuseelementes (12) hinaussteht, wobei der Deckel im Wesentlichen wannenförmig ausgebildet ist.

11. Verfahren zur Herstellung eines Gehäuses (10) nach einem der vorhergehenden Ansprüche, wobei die zweite Schweißnahtlage (44) als Schweißnaht mit ungleichen Schenkeln ausgebildet ist, wobei der lange Schenkel der zweiten Schweißnahtlage (44) dem mittels Durchgussverfahren hergestellten Gehäuseelement (12, 14) zugewandt ausgebildet ist.

12. Verfahren zur Herstellung eines Gehäuses (10) nach einem der vorhergehenden Ansprüche, wobei das zweite Gehäuseelement (14) mittels Umformen, insbesondere durch das Tiefziehen einer Knetlegierung, erstellt wird.

13. Verfahren zur Herstellung eines Gehäuses (10) nach einem der vorhergehenden Ansprüche, wobei das mittels Druckgussverfahren hergestellte Gehäuseelement (12, 14) aus einer vor dem Einbringen in eine Druckgussform, insbesondere ausreichend, entgasten Schmelze hergestellt wird, wobei das Druckgussverfahren in einer Schutzatmosphäre, insbesondere einer Atmosphäre aus Stickstoff, durchgeführt wird.

14. Verfahren zur Herstellung eines Gehäuses (10) nach einem der vorhergehenden Ansprüche, wobei die Elektronik vor dem Mehrlagen-Laserstrahlschweißen in einem der (12, 14) Gehäuseelemente angeordnet wird.

15. Verfahren zur Herstellung eines Gehäuses (10) nach einem der vorhergehenden Ansprüche, wobei zum Laserstrahlschweißen ein Festkörperlaser, insbesondere ein Nd:YAG-Laser verwendet wird.

16. Elektronikgehäuse hergestellt nach einem Verfahren gemäß einem oder mehrerer der vorhergehenden Ansprüche, wobei das Elektronikgehäuse wenigstens ein erstes Gehäuseelement (12) und ein zweites Gehäuseelement (14) aufweist, wobei die Gehäuseelemente (12, 14) Aluminium oder eine Aluminiumlegierung umfassen, und mindestens eines der Gehäuseelemente (12, 14) mittels eines Druckgussverfahrens hergestellt wird, und wobei die Gehäuseelemente (12, 14) mittels Laserschweißen fluiddicht miteinander verbunden sind und zwischen dem ersten Gehäuseelement ( 12) und dem zweiten Gehäuseelement ( 14) zumindest teilweise eine Mehrlagen-Laserschweißnaht (40) ausgebildet ist, wobei eine Mehrlagenschweißnaht (40) der Mehrlagen-Laserstrahlschweißen aus wenigstens einer ersten Schweißnahtlage und wenigstens einer zweiten Schweißnahtlage ausgebildet ist, wobei die zweite Schweißnahtlage auf der ersten Schweißnahtlage aufgebracht wird, und wobei die Breite (48) der ersten Schweißnahtlage (42) kleiner als die Breite (46) der zweiten Schweißnahtlage (44) ausgebildet ist.

## Claims

1. Method for producing a housing (10) for electronics (18), in particular for controlling an electric motor, wherein the housing (10) is formed by a first housing element (12) and a second housing element (14), wherein the housing elements (12, 14) comprise aluminium or an aluminium alloy, and at least one of the housing elements (12, 14) is produced by means of a diecasting process, wherein the housing elements (12, 14) are at least partly connected to one another in a fluid-tight manner by means of multilayer laser beam welding, wherein a multilayer weld seam (40) of the multilayer laser beam welding is made up of at least a first weld-seam layer (42) and at least a second weld-seam layer (44), wherein the second weld-seam layer is applied on top of the first weld-seam layer, **characterized in that** the width (48) of the first weld-seam layer (42) is made to be less than the width of the second weld-seam layer (44).

2. Method for producing a housing (10) according to Claim 1, wherein at least one weld-seam layer (42, 44) of the at least a first weld seam layer (42) and at least a second weld-seam layer (44) is created by means of beam oscillation, in particular by means of a substantially circular laser beam trajectory.

3. Method for producing a housing (10) according to one of the preceding claims, wherein the multilayer weld seam (40) is formed as substantially pore-free in the region of a weld-seam layer (42, 44) facing a free surface of the multilayer weld seam (40).

4. Method for producing a housing (10) according to either of Claims 2 and 3, wherein a ratio between a feed rate of the laser beam and the beam oscillation of the laser beam is made to be between 0.2 (mm/s)/Hz and 0.4 (mm/s)/Hz, in particular substantially between 0.25 (mm/s)/Hz and 0.35 (mm/s)/Hz.

5. Method for producing a housing (10) according to one of the preceding claims, wherein the depth (50) of the first weld-seam layer (42) is made to be greater than the depth (52) of the second weld-seam layer (44).

6. Method for producing a housing (10) according to one of the preceding claims, wherein the multilayer weld seam (40) is formed in regions (62, 27) in which the laser weld-seam follows a sharply angled course.

7. Method for producing a housing (10) according to one of the preceding claims when dependent on Claim 2, wherein the at least a first weld-seam layer (42) and the at least a second weld-seam layer (44) are created by means of a substantially circular laser beam trajectory, wherein the radius of the substantially circular laser beam trajectory of the second weld-seam layer (44) is made to be greater, in particular between 20% and 40% greater, 30% and 35% greater, than the radius of the substantially circular laser beam trajectory of the first weld-seam layer (42).

8. Method for producing a housing (10) according to one of the preceding claims, wherein the second housing element (14) is formed as a cover for the first housing element (12), wherein the first housing element (12) has a recess (16), which is covered by the second housing element (14).

9. Method for producing a housing (10) according to one of the preceding claims, wherein the first housing element (12) and the second housing element (14) are arranged in relation to one another in the laser beam region with an angular joint, in particular a flanged joint.

10. Method for producing a housing (10) according to one of the preceding claims when dependent on Claim 8, wherein the second housing element (14), formed as a cover, protrudes in the direction of extent (34) of the laser beam in a projection (38) beyond the contour of the first housing element (12), wherein the cover is substantially of a pan-shaped form.

11. Method for producing a housing (10) according to one of the preceding claims, wherein the second weld-seam layer (44) is formed as a weld seam with unequal legs, wherein the long leg of the second weld-seam layer (44) is formed facing the housing element (12, 14) produced by means of a diecasting process.

12. Method for producing a housing (10) according to one of the preceding claims, wherein the second housing element (14) is created by means of forming, in particular by the deep drawing of a wrought alloy.

13. Method for producing a housing (10) according to one of the preceding claims, wherein the housing element (12, 14) produced by means of a diecasting process is produced from a melt which has been degassed, in particular sufficiently degassed, before being introduced into a diecasting mould, wherein the diecasting process is performed in a protective atmosphere, in particular a nitrogen atmosphere.

14. Method for producing a housing (10) according to one of the preceding claims, wherein the electronics are arranged in one of the housing elements (12, 14) before the multilayer laser beam welding.

15. Method for producing a housing (10) according to one of the preceding claims, wherein a solid-state laser, in particular an Nd:YAG laser, is used for the laser beam welding.

16. Electronics housing produced by a method according to one or more of the preceding claims, wherein the electronics housing has at least a first housing element (12) and a second housing element (14), wherein the housing elements (12, 14) comprise aluminium or an aluminium alloy, and at least one of the housing elements (12, 14) is produced by means of a diecasting process, and wherein the housing elements (12, 14) are connected to one another in a fluid-tight manner by means of laser welding and between the first housing element (12) and the second housing element (14) at least partly a multilayer weld seam layer (40) is formed, wherein a multilayer weld seam (40) of the multilayer laser beam welding is made up of at least a first weld-seam layer and at least a second weld-seam layer, wherein the second weld-seam layer is applied on top of the first weld-seam layer, and wherein the width (48) of the first weld-seam layer (42) is made to be less than the width (46) of the second weld-seam layer (44).

## Revendications

1. Procédé permettant de fabriquer un boîtier (10) pour une électronique (18), en particulier pour commander un moteur électrique, le boîtier (10) étant formé par un premier élément de boîtier (12) et un deuxième élément de boîtier (14), dans lequel les éléments de boîtier (12, 14) comprennent de l'aluminium ou un alliage d'aluminium, et au moins l'un des éléments de boîtier (12, 14) est fabriqué au moyen d'un procédé de coulée sous pression, les éléments de boîtier (12, 14) étant reliés au moins partiellement entre eux de manière étanche aux fluides au moyen d'un soudage par faisceau laser multicouche, dans lequel un joint de soudure multicouche (40) du soudage par faisceau laser multicouche est réalisé par au moins une première couche de joint de soudure (42) et au moins une deuxième couche de joint de soudure (44), dans lequel la deuxième couche de joint de soudure est appliquée sur la première couche de joint de soudure, **caractérisé en ce que** la largeur (48) de la première couche de joint de soudure (42) est inférieure à la largeur de la deuxième couche de joint de soudure (44).

2. Procédé permettant de fabriquer un boîtier (10) selon la revendication 1, dans lequel au moins une couche de joint de soudure (42, 44) de ladite au moins une première couche de joint de soudure (42) et au moins une deuxième couche de joint de soudure (44) est réalisée au moyen d'une oscillation de faisceau, en particulier au moyen d'une trajectoire de faisceau laser substantiellement circulaire.

3. Procédé permettant de fabriquer un boîtier (10) selon l'une quelconque des revendications précédentes, dans lequel le joint de soudure multicouche (40) est réalisé de manière substantiellement sans pores au niveau d'une couche de joint de soudure (42, 44) tournée vers une surface libre du joint de soudure multicouche (40).

4. Procédé permettant de fabriquer un boîtier (10) selon l'une quelconque des revendications 2 ou 3, dans lequel un rapport entre une vitesse d'avance du faisceau laser et l'oscillation de faisceau du faisceau laser est compris entre 0,2 (mm/s)/Hz et 0,4 (mm/s)/Hz, en particulier substantiellement entre 0,25 (mm/s)/Hz et 0,35 (mm/s)/Hz.

5. Procédé permettant de fabriquer un boîtier (10) selon l'une quelconque des revendications précédentes, dans lequel la profondeur (50) de la première couche de joint de soudure (42) est supérieure à la profondeur (52) de la deuxième couche de joint de soudure (44).

6. Procédé permettant de fabriquer un boîtier (10) selon l'une quelconque des revendications précédentes, dans lequel le joint de soudure multicouche (40) est réalisé dans des zones (62, 27) dans lesquelles le tracé du joint de soudure au laser est réalisé de manière angulaire.

7. Procédé permettant de fabriquer un boîtier (10) selon l'une quelconque des revendications précédentes lorsqu'elles dépendent de la revendication 2, dans lequel ladite au moins une première couche de joint de soudure (42) et ladite au moins une deuxième couche de joint de soudure (44) sont réalisées au moyen d'une trajectoire de faisceau laser substantiellement circulaire, dans lequel le rayon de la trajectoire de faisceau laser substantiellement circulaire de la deuxième couche de joint de soudure (44) est supérieur, en particulier supérieur entre 20 % et 40 %, supérieur entre 30 % et 35 %, au rayon de la trajectoire de faisceau laser substantiellement circulaire de la première couche de joint de soudure (42).

8. Procédé permettant de fabriquer un boîtier (10) selon l'une quelconque des revendications précédentes, dans lequel le deuxième élément de boîtier (14) est réalisé sous forme de couvercle pour le premier élément de boîtier (12), le premier élément de boîtier (12) présentant un évidement (16) qui est recouvert par le deuxième élément de boîtier (14).

9. Procédé permettant de fabriquer un boîtier (10) selon l'une quelconque des revendications précédentes, dans lequel le premier élément de boîtier (12) et le deuxième élément de boîtier (14) sont disposés l'un par rapport à l'autre dans la zone de soudage au laser en joint de cornière-membrure, en particulier en soudure sur bords relevés.

10. Procédé permettant de fabriquer un boîtier (10) selon l'une quelconque des revendications précédentes lorsqu'elles dépendent de la revendication 8, dans lequel le deuxième élément de boîtier (14), réalisé sous forme de couvercle, dépasse dans la direction d'extension de faisceau laser (34) dans un surplomb (38) au-delà du contour du premier élément de boîtier (12), le couvercle étant réalisé substantiellement en forme de cuvette.

11. Procédé permettant de fabriquer un boîtier (10) selon l'une quelconque des revendications précédentes, dans lequel la deuxième couche de joint de soudure (44) est réalisée sous forme de joint de soudure à branches inégales, dans lequel la branche longue de la deuxième couche de joint de soudure (44) est réalisée en étant tournée vers l'élément de boîtier (12, 14) fabriqué au moyen du procédé de coulée sous pression.

12. Procédé permettant de fabriquer un boîtier (10) selon l'une quelconque des revendications précédentes, dans lequel le deuxième élément de boîtier (14) est créé par façonnage, en particulier par emboutissage d'un alliage corroyé.

13. Procédé permettant de fabriquer un boîtier (10) selon l'une quelconque des revendications précédentes, dans lequel l'élément de boîtier (12, 14) fabriqué au moyen d'un procédé de coulée sous pression est fabriqué à partir d'une fonte dégazée, en particulier suffisamment dégazée, avant l'introduction dans un moule de coulée sous pression, le procédé de coulée sous pression étant effectué dans une atmosphère contrôlée, en particulier une atmosphère d'azote.

14. Procédé permettant de fabriquer un boîtier (10) selon l'une quelconque des revendications précédentes, dans lequel l'électronique est disposée dans l'un des éléments de boîtier (12, 14) avant le soudage par faisceau laser multicouche.

15. Procédé permettant de fabriquer un boîtier (10) selon l'une quelconque des revendications précédentes, dans lequel un laser à corps solide, en particulier un laser Nd:YAG, est utilisé pour le soudage au laser.

16. Boîtier électronique, fabriqué selon un procédé selon l'une quelconque des revendications précédentes, dans lequel le boîtier électronique présente au moins un premier élément de boîtier (12) et un deuxième élément de boîtier (14), dans lequel les éléments de boîtier (12, 14) comprennent de l'aluminium ou un alliage d'aluminium, et au moins l'un des éléments de boîtier (12, 14) est fabriqué au moyen d'un procédé de coulée sous pression, et dans lequel les éléments de boîtier (12, 14) sont reliés entre eux de manière étanche aux fluides au moyen d'un soudage au laser, et un joint de soudure multicouche (40) est réalisé au moins partiellement entre le premier élément de boîtier (12) et le deuxième élément de boîtier (14), dans lequel un joint de soudure multicouche (40) du soudage par faisceau laser multicouche est réalisé par au moins une première couche de joint de soudure et au moins une deuxième couche de joint de soudure, dans lequel la deuxième couche de joint de soudure est appliquée sur la première couche de joint de soudure, et dans lequel la largeur (48) de la première couche de joint de soudure (42) est inférieure à la largeur (46) de la deuxième couche de joint de soudure (44).
